Europäisches Patentamt

European Patent Office

Office européen des brevets

(11) Publication number: 0 350 219
A2

# EUROPEAN PATENT APPLICATION

(21) Application number: 89306679.5

(51) Int. Cl.⁴: H03K 3/356

(22) Date of filing: 30.06.89

(30) Priority: 06.07.88 US 215685

(43) Date of publication of application:
10.01.90 Bulletin 90/02

(84) Designated Contracting States:
DE FR GB

(71) Applicant: NCR CORPORATION
World Headquarters
Dayton, Ohio 45479(US)

(72) Inventor: Suthar, Mukesh Bhogilal
982 Planetree Place
Sunnyvale California 94086(US)
Inventor: Sanwo, Ikuo Jimmy
939 Lacebark Street
San Marcos California 92069(US)

(74) Representative: Robinson, Robert George
International Patent Department NCR Limited
915 High Road North Finchley
London N12 8QJ(GB)

(54) CMOS latch circuit.

(57) A no-leak CMOS latch circuit (10) has a data input line (12) for supplying a low or high data signal, a single clock input line (14), a data storage node (16), a complementary data output node (18), and first and second power supply terminals. The latch (10) has an NMOS input transistor (24) for supplying either a low or degraded high data signal to the data storage node (16). A CMOS inverter (26) connects the data storage node (16) to the complementary data output node (18). A dynamic inverter (32) including three series-connected transistors (34,36,38) responds to the signals on the clock input line (14) and output node (18) to connect either the first or second power supply terminals to the data storage node (18). In this manner the data storage node (16) is maintained at a level that prevents static power dissipation from the CMOS inverter (26).

FIG. 4

## CMOS LATCH CIRCUIT

This invention relates to CMOS latch circuits of the kind having a data input line adapted to supply a high or a low data signal, a single clock input line, a data storage node, a complementary data output node, first and second power supply terminals, input means responsive to a signal from said clock input line to supply a low or degraded high signal from a data input line to said data storage node, and a CMOS inverter including first and second series connected transistors, said inverter being connected between said storage node and said complementary data output node.

A latch is a commonly used component in microprocessors and many other microelectronic devices. It operates by sensing a binary data signal, either a high or low voltage signal, and storing this voltage after the signal is removed. In one form the latch may simply be a capacitor connected to a switch so that the capacitor charges in response to an input signal when the switch is closed and stores that signal or charge when the switch is open.

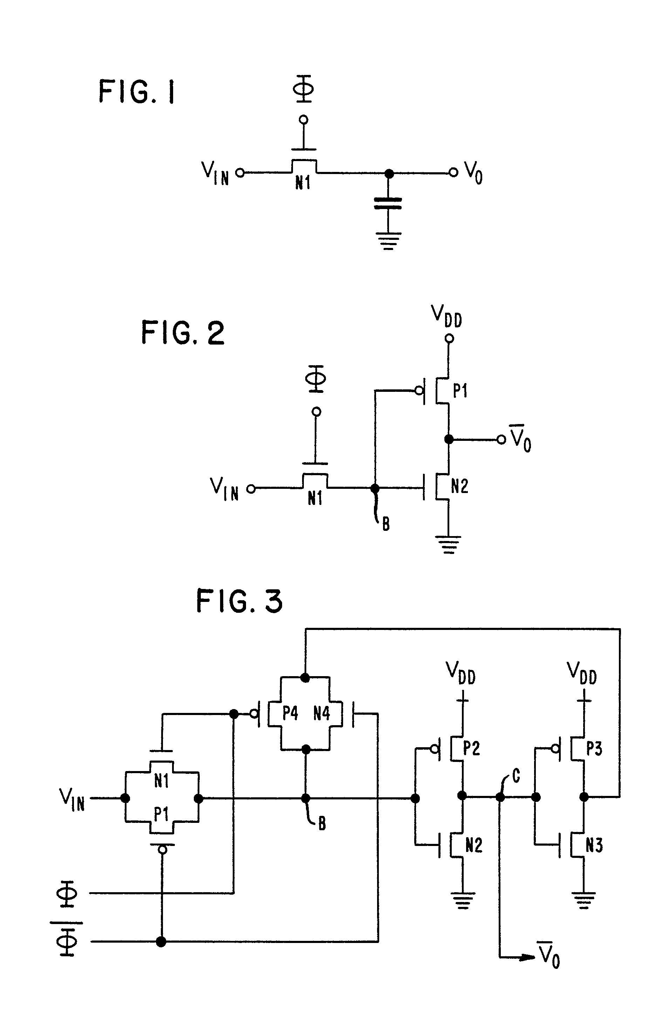

FIG. 1 shows such a latch where the binary input signal is represented by $V_{in}$, and the stored signal by $V_o$. The switch is an NMOS field effect transistor $N_1$, which turns on or off in response to a high or low clock signal Phi. In its high state Phi must be large enough to overcome the threshold voltage $V_{th}$ of $N_1$. As long as a high Phi signal is applied to $N_1$, $V_o$ will charge towards the value of $V_{in}$. However, as is well known, $V_o$ can never exceed the value of Phi minus $V_{th}$. For example, if the high values of Phi and $V_{in}$ are both equal to 5 volts D.C. and $V_{th}$ is equal to 1 volt D.C., $V_o$ can not exceed 4 volts.

Another relatively simple latch circuit is shown in FIG. 2. wherein the capacitor is replaced by a CMOS inverter. The CMOS inverter consists of a PMOS field effect transistor $P_1$ in series with an NMOS field effect transistor $N_2$. The gates of $P_1$ and $N_2$ are connected to node B, their drains are connected to an inverted output signal $/V_o$, and their sources are connected between power terminals $V_{DD}$ and ground. As with the FIG 1. latch, data is "read" into the latch when the clock signal Phi goes high. Assuming the high values of $V_{in}$ and Phi are the same as $V_{DD}$, the latch will leak during certain static conditions. More specifically, a high value of $V_{in}$ will be stored at node B at the degraded value of $V_{DD}-V_{th}$. This value is less than is required to completely shut off $P_1$, but it is generally large enough to turn on $N_2$. Thus, $/V_o$ will be pulled low (to the ground potential) but there will be a small steady state or static current leakage from $V_{DD}$ through $P_1$ and $N_2$ to ground. In many applications such losses are unacceptable.

A circuit which overcomes the aforementioned leakage problems is shown in FIG. 3. Data is latched into the circuit through a P-N combination transfer gate consisting of NMOS field effect transistor $N_1$ and PMOS field effect transistor $P_1$. Two clock signals Phi and /Phi are applied to the $N_1$ and $P_1$ gates, respectively. The P-N gate characteristically passes a high $V_{in}$ signal without a $V_{th}$ degradation. In order to "hold" storage node B at the value received from $V_{in}$, two CMOS inverters follow node B. These inverters consist of MOS field effect transistors $P_2$ and $N_2$, and $P_3$ and $N_3$, respectively. A non-degraded high voltage at node B (equal to $V_{DD}$) completely turns off $P_2$ so that $/V_0$ is pulled to ground without any leakage through $P_2$. Similarly, a ground potential at node C is sufficient to completely turn off $N_3$ so that a feedback loop is connected from $V_{DD}$ to node B. A second P-N combination transfer gate consisting of $P_4$ and $N_4$ and connected to Phi and /Phi, respectively is disposed within the feedback line. This isolates node B from $V_{DD}$ when data is being received from $V_{in}$.

The latch shown in FIG 3. is effective for preventing static power dissipation. However, it requires eight transistors and two clock signal lines. In many microprocessor related circuits, latches can consume as much as 40% or more of the layout area. Thus, it is highly desirable to reduce the number and/or size of components comprising a latch.

A CMOS latch circuit corresponding to the circuit shown in Fig. 3 herein is disclosed in U.S. Patent No. 4,484,087 (see especially Figs 1A to 1D and the associated description thereof). The U.S. Patent also discloses (see especially Fig. 2 thereof and the associated description), a CMOS latch circuit of the kind specified hereinabove, which employs five transistors and a high impedance leakage resistor which serves to discharge leakage current and which in one embodiment may be implemented as a field effect transistor having its gate electrode connected to ground, its gate insulating layer formed with a relatively high thickness, and with a relatively narrow channel. This known CMOS latch circuit has the advantage that it can be fabricated with a low chip area. However, the latch has the disadvantage that power is dissipated as a result of the aforementioned leakage current.

It is an object of the present invention to provide a CMOS latch circuit of the kind specified, which has no static power dissipation, and which can be implemented with a low chip area.

Therefore, according to the present invention, there is provided a CMOS latch circuit of the kind specified, characterized by series connected third, fourth and fifth transistors, said third and fifth transistors having their gates connected to said complementary data output node, and said fourth transistor having its gate connected to said clock input line, in that said third transistor has its source-drain path connected between said first power supply terminal and said data storage node and in that said fourth and fifth transistors are series-connected between said data storage node and said second power supply terminal.

Two embodiments of the present invention will now be described by way of example, with reference to the accompanying drawings, in which:-

Figure 1 is a schematic diagram of a prior art latch.

Figure 2 is a schematic diagram of a second prior art latch.

Figure 3 is a schematic diagram of a third prior art latch.

Figure 4 is a schematic diagram of a no-leak CMOS latch according to one form of the present invention.

Figure 5 is a schematic diagram of a no-leak CMOS latch according to another form of the present invention.

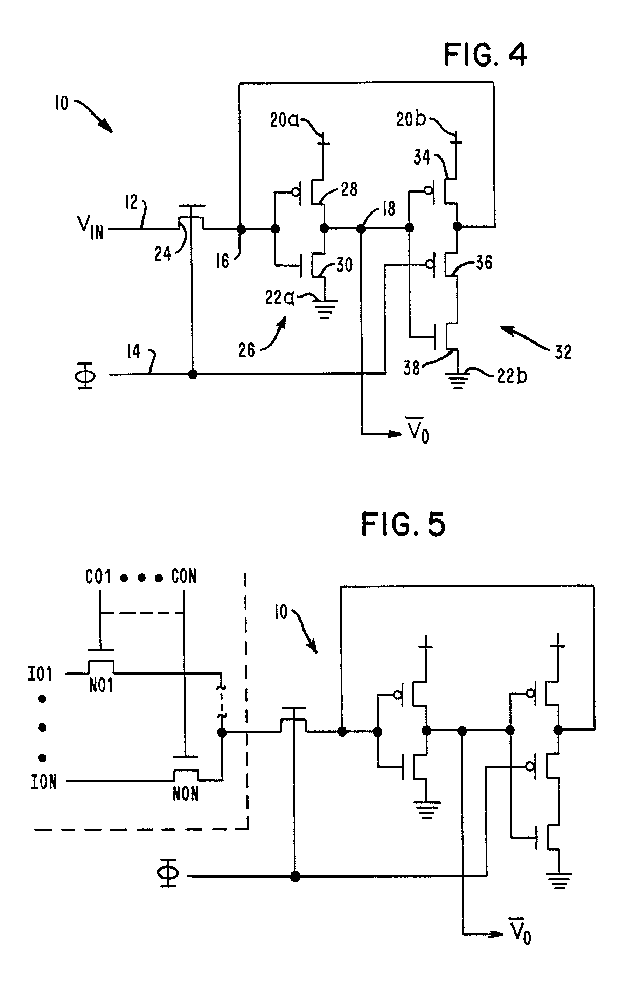

Figure 4 shows a no-leak CMOS latch 10 according to one form of the present invention. Latch 10 has a data input line 12, a single clock input line 14, a data storage node 16, a complementary data output node 18, first power supply terminals 20a and 20b, and second power supply terminals 22a and 22b. Power supply terminals 20a and 20b are generally at the same first voltage potential and may according to one embodiment of the invention be connected. Similarly, power supply terminals 22a and 22b are generally at the same second voltage potential and may be connected. In the embodiment shown in Figure 4, terminals 22a and 22b are connected to ground.

Latch 10 further comprises means, in the form of NMOS field effect transistor 24, for supplying a bilevel data signal $V_{in}$ to data storage node 16. The gate of transistor 24 is connected to clock input line 14 and its source and drain are connected between data input line 12 and data storage node 16. Transistor 24 is responsive to a high or low signal Phi supplied on clock input line 14. More specifically, when Phi goes high, transistor 24 conducts and the data signal $V_{in}$ on line 12 will be provided to data storage node 16. However, as noted previously, the value of the charge on node 16 cannot exceed Phi less the threshold voltage $V_{th}$ of transistor 24. For most applications of the present invention the "high" values of Phi and $V_{in}$ will be the same. Thus, when Phi and $V_{in}$ are high

transistor 24 will provide a degraded high data signal $(V_{in}-V_{th})$ to storage node 16.

Latch 10 further comprises a CMOS inverter 26 connecting data storage node 16 and complementary data output node 18. Inverter 26 includes series connected PMOS field effect transistor 28 and NMOS field effect transistor 30. The drains of transistors 28 and 30 connected to complementary data output node 18, the gates are connected to data storage node 16 and the sources are connected to power supply terminals 20a and 22a, respectively.

Latch 10 further comprises a dynamic inverter 32 for connecting either power supply terminal 20b or 22b to data storage node 16. Inverter 32 includes PMOS field effect transistor 34, PMOS field effect transistor 36 and NMOS field effect transistor 38. Transistors 34, 36 and 38 are series connected with the gate of transistor 34 connected to node 18, its drain connected to power supply terminal 20b and its source connected to data storage node 16. A feature of PMOS transistor 34 is that its channel has a relatively small width to length ratio, the significance of which will become clear later. Transistors 36 and 38 are connected between data storage node 16 and power supply terminal 22b. The gate of transistor 38 is connected to complementary data output node 18 and the gate of transistor 36 is connected to clock input line 14.

In operation, a low or high data signal will be supplied on data input line 12 and a low or high clock signal Phi will be supplied by clock input line 14. Power supply terminals 20a and 20b will be connected to a high first potential relative to a low second potential at power supply terminals 22a and 22b. According to a preferred embodiment of the subject invention, the high data signal, high clock signal and power supply terminals 20a and 20b are each at substantially same first potential. Similarly, the low data signal, low clock signal and power supply terminals 22a and 22b are each at substantially the same second potential.

As long as Phi is low, no data will enter latch 10. When Phi goes high, transistor 24 will conduct thereby transmitting the data input signal $V_{in}$ to data storage node 16. If $V_{in}$ is high it will undergo a voltage drop through transistor 24 roughly equivalent to the threshold voltage $V_{th}$ of transistor 24. In this manner a degraded high data signal $(V_{in}-V_{th})$ will be supplied to data storage node 16.

The degraded high signal at node 16 will turn on transistor 30 which will pull node 18 to the low potential of power supply terminal 22a. The degraded high signal at node 16 will almost completely shut off transistor 28. However, in order to completely prevent current flow through transistor 28 the potential at node 16 must be at least as high as power supply terminal 20a. Thus, as long as the potential at node 16 is one threshold ($V_{th}$) below the potential at terminal 20a, a small but measurable static power dissipation or leakage occurs through CMOS inverter 26.

Inverter 32 responds to the signal on the complementary data output node 18 by connecting either power supply terminal 20b or 22b to data storage node 16. More specifically, if the signal on node 18 is low transistor 34 conducts thereby connecting power supply terminal 20b to node 16 which boosts the voltage on node 16 to a (nondegraded) high value. The potential of node 16 will now be essentially the same as power supply terminal 20a, completely turning off transistor 28, thereby preventing static power leakage.

When clock input line 14 "admits" a low data signal to node 16, transistor 28 is turned on and transistor 30 is turned off which brings node 18 to the high value of power supply terminal 20a. The high value at node 18 turns transistor 34 off and turns transistor 38 on. As long as no data is being admitted to latch 10, clock input line 14 is low which keeps transistor 36 on. Thus, node 16 is maintained at its low value by virtue of its connection through transistors 36 and 38 to power supply terminal 22b.

Transistor 36 of inverter 32 responds to the clock signal Phi by conducting only when Phi is low. When Phi is high and data is being "read" into latch 10, transistor 36 turns off, thereby isolating power supply terminal 22b. For example, when data storage node 16 is initially low, it is connected to power supply terminal 22b. If a high value of $V_{in}$ is then admitted by a high Phi signal, transistor 36 becomes an open circuit which prevents a short circuit connection between $V_{in}$ and terminal 22b.

On the other hand, when data storage node 16 is initially high, it is connected to power supply terminal 20b. If a low value of $V_{in}$ is admitted by a high Phi signal, transistor 34 will tend to oppose a change in its state by virtue of the aforesaid connection. Restated, node 16 will be driven by both the low $V_{in}$ and the high value of power supply terminal 20b. The resistance of transistor 34 is inversely proportional to its width to channel length ratio (w/l). Thus, by selecting a relatively small w/l, node 16 will tend to fall towards the low value of $V_{in}$ which will cause a low value on node 18 thereby turning off transistor 34. For example, in one embodiment w/l will be approximately one fifth the w/l value of NMOS transistor 38. An additional benefit of the small w/l of transistor 34 is that its reduced size will further reduce the layout area needed for latch 10.

Figure 5 shows another form of the present invention in which $V_{in}$ is provided by an N channel multiplexer. That is, one of N different input lines denoted I01 through I0N is input to latch 10, through an NMOS field effect transistor N01 through N0N, in response to one of the control signals C01 through C0N, respectively. A high input signal will be degraded as it passes through an NMOS transistor in much the same manner as described in transistor 24 in Figure 4. The subject invention will be effective to prevent leakage in latch 10 as described with respect to the Figure 4 embodiment.

The present invention has a reduced layout area compared with prior art latches. This is achieved, in part, by the use of only six transistors and the relatively small size of transistor 34. The use of only one clock input line further reduces the layout area and simplifies the interface connections.

## Claims

1. A CMOS latch circuit having a data input line (12) adapted to supply a high or a low data signal, a single clock input line (14), a data storage node (16), a complementary data output node (18), first and second power supply terminals (20a,20b;22a,22b), input means responsive to a signal from said clock input line (14), to supply a low or degraded high signal from a data input line (12) to said data storage node (16), and a CMOS inverter including first and second series connected transistors (25,30), said inverter being connected between said storage node (16), and said complementary data output node (18), characterized by series connected third, fourth and fifth transistors (34,36,38), said third and fifth transistors having their gates connected to said complementary data output node (18), and said fourth transistor having its gate connected to said clock input line (14), in that said third transistor (34) has its source-driven path connected between said first power supply terminal (20b) and said data storage node (16) and in that said fourth and fifth transistors (36,38) are series-connected between said data storage node (16) and said second power supply terminal (22b)

2. A CMOS latch circuit according to claim 1, characterized in that said first transistor (28) is a PMOS transistor, said second transistor (30) is an NMOS transistor, the drains of said first and second transistors (28,30) are connected to said complementary data output node (18), the gates are connected to said data storage node (16) and the sources are connected to said first and second power supplies (20a,22a) respectively.

3. A CMOS latch circuit according to claim 2, characterized in that said third and fourth transistors (34,36) are PMOS transistors and said fifth transistor (38) is an NMOS transistor.

4. A CMOS latch circuit according to any one of the preceding claims, characterized in that said third transistor (34) has a relatively small width-to-length ratio.

5. A CMOS latch circuit according to any one of the preceding claims, characterized in that said input means includes a sixth transistor (24) having its gate connected to said clock input line (14) and its source-drain path connected between said data input line (12) and said data storage node (16).

6. A CMOS circuit according to claim 5, characterized in that said sixth transistor is an NMOS transistor (24).

7. A CMOS circuit according to any one of the preceding claims, characterized in that said data input line (12) receives its input from an N channel multiplexer.

FIG. 1

FIG. 2

FIG. 3

EP 0 350 219 A2

FIG. 4

FIG. 5